# EUROPEAN PATENT APPLICATION

(11) **EP 4 432 443 A1**
(43) Date of publication of application: **18.09.2024**
(21) Application number: 23802528.2
(22) Date of filing: 29.03.2023
(51) Int. Cl.: H01M 50/284, H01M 50/247, H05K 1/02

(54) **PROTECTION BOARD, BATTERY, AND ELECTRONIC APPARATUS**

(30) Priority: 11.05.2022 CN 202210514065
(71) Applicant: Zhuhai Cosmx Power Co., Ltd., Zhuhai, Guangdong 519180 (CN)
(72) Inventor: SHAO, Guojie, Zhuhai, Guangdong 519180 (CN); LUO, Zihao, Zhuhai, Guangdong 519180 (CN)
(74) Representative: Bandpay & Greuter
(86) International application number: PCT/CN2023/084708
(87) International publication number: WO 2023/216752

(57) **Abstract**

Embodiments of the present disclosure relate to the technical field of batteries, in particular, to a protection board, a battery and an electronic device. The protection board includes a protection board body and a flexible circuit board connected in sequence, where a puller assembly is provided on an end of the flexible circuit board away from the protection board body. In the present disclosure, since the puller assembly is arranged on the protection board, by means of directly grabbing the puller assembly, the battery can be disassembled or replaced, which avoids a safety risk of cracking of or damage to the flexible circuit board and thus seriously affecting the safety performance and service life of the battery due to directly taking the flexible circuit board with hands or devices.

## Description

This application claims priority to the Chinese Patent Application No. 202210514065.2, which was filed with the China National Intellectual Property Administration on May 11, 2022 and titled "Protection board, battery and electronic device". The disclosure of the above patent application is incorporated herein by reference in its entirety.

### TECHNICAL FIELD

The present disclosure relates to the technical field of batteries, and in particular, to a protection board, a battery and an electronic device.

### BACKGROUND

With the rapid development of mobile communication industry and electronic products in our country, lithium-ion batteries have been widely used due to their various obvious advantages such as high energy density, high voltage system, long cycle, and high safety.

In order to make the appearance of electronic products thinner, to arrange the internal components of the products in a more scientific way, and to make the bodies of electronic products tight and not loose, many electronic products, such as more and more high-end mobile phones, currently choose built-in batteries. However, at present, it is inconvenient to disassemble the built-in battery, and when disassembling or replacing the built-in battery, customers will directly grab the flexible circuit board with their hands, or use a tool to grab the flexible circuit board, but whether the flexible circuit board is grabbed by hands or by the tool, there is a certain risk of damage to the flexible circuit board or a connector. For example, the flexible circuit board may be cracked or damaged, seriously affecting the safety performance and service life of the battery.

### SUMMARY

Embodiments of the present disclosure provide a protection board, a battery and an electronic device to solve a problem that when disassembling or replacing an existing built-in battery, the battery is prone to cracking or damage.

In order to solve the above problem, a first aspect of the present disclosure provides a protection board, which includes a protection board body and a flexible circuit board connected in sequence, and a puller assembly is provided on an end of the flexible circuit board away from the protection board body.

Further, the puller assembly includes a fixing portion, and the fixing portion is fixedly connected to the flexible circuit board.

Further, an adhesive layer is provided between the fixing portion and the flexible circuit board, one side of the adhesive layer is bonded to the flexible circuit board, and the other side of the adhesive layer is bonded to the fixing portion.

Further, the puller assembly further includes a puller portion, the puller portion is connected to the fixing portion, and the puller portion is bent relative to the fixing portion.

Further, an included angle between the puller portion and the fixing portion ranges from 90° to 150°.

Further, a length of the puller portion ranges from 1 mm to 100 mm.

Further, the fixing portion and the puller portion are integrally formed.

A second aspect of the present disclosure provides a battery, including a battery body, a protection assembly wrapping the battery body inside thereof, and a protection board, where the protection board is the protection board according to any embodiments of the first aspect.

Further, the protection board body is located inside the protection assembly, the protection board body is electrically connected to the battery body, the flexible circuit board extends to outside of the protection assembly, and the puller assembly is provided on an end the flexible circuit board away from the protection board body.

Further, the protection assembly includes a plastic frame, a plastic frame head, a label protection layer and a steel sheet, where the plastic frame and the plastic frame head are enclosed to form an accommodation cavity to accommodate the battery body and the protection board body, the label protection layer is wrapped outside of the plastic frame, and the steel sheet is arranged on the label protection layer.

A third aspect of the present disclosure provides an electronic device, which includes the battery according to any one embodiments of the second aspect.

In the protection board, the battery and the electronic device described in the present disclosure, a puller assembly is provided on the protection board. By directly grabbing the puller assembly, the battery can be disassembled or replaced, which avoids a safety risk of cracking of or damage to the flexible circuit board and thus seriously affecting the safety performance and service life of the battery due to directly taking the flexible circuit board with hands or devices. The present disclosure facilitates the disassembly and replacement of the battery, improves the safety performance of the battery and electronic device system end, has a simple structure, and is convenient to be assembled and beneficial to reducing production cost of the battery.

### BRIEF DESCRIPTION OF DRAWINGS

FIG. 1 is a schematic front structural view of a built-in battery provided in an embodiment of the present disclosure.
FIG. 2 is a schematic side structural view of a built-in battery provided in an embodiment of the present disclosure.
FIG. 3 is a schematic exploded structural view of a built-in battery provided in an embodiment of the present disclosure.
FIG. 4 is a schematic front structural view of a protection board provided in an embodiment of the present disclosure.
FIG. 5 is a schematic side structural view of a protection board provided in an embodiment of the present disclosure.
FIG. 6 is a schematic front structural view of a flexible circuit board provided in an embodiment of the present disclosure.
FIG. 7 is a schematic side structural view of a flexible circuit board provided in an embodiment of the present disclosure.
FIG. 8 is a schematic front structural view of a puller assembly provided in an embodiment of the present disclosure.
FIG. 9 is a schematic side structural view of a puller assembly provided in an embodiment of the present disclosure.

Explanation of reference signs: 1-Battery body; 2-Protection assembly; 3-Protection board; 4-Puller assembly; 21-Plastic frame; 22-Plastic frame head; 23-First label protection layer; 24-Second label protection layer; 25-Steel sheet; 31-Protection board body; 32-Flexible circuit board; 41-Fixing portion; 42-Puller portion.

### DESCRIPTION OF EMBODIMENTS

The technical solutions of the present disclosure are described clearly in detail below with reference to the accompanying drawings. In the description of the present disclosure, it should be noted that the terms "center", "longitudinal", "transverse", "length", "width", "thickness", "upper", "lower", "front", "rear", "left", "right", "vertical", "perpendicular", "horizontal", "top", "bottom", "inside", "outside", etc. are indicative of orientations or positional relationships based on the accompanying drawings, and are only to facilitate the description of the present disclosure and simplify the description, and do not indicate or imply that the devices or elements referred to must have specific orientations, or be constructed and operated in specific orientations, and therefore cannot be understood as a limitation to the present disclosure. In addition, the terms "first" and "second" are used for the purpose of description only and cannot be understood as indicating or implying relative importance or implicitly indicating the quantity of indicated technical features. Thus, features defined as "first" and "second" may explicitly or implicitly include one or more described features.

In the description of this specification, the term "on the basis of the above-mentioned embodiment" means that the specific features, structures, materials or characteristics described in conjunction with the embodiment or example are included in at least one preferred embodiment or preferred example of the present disclosure. In this specification, schematic expressions of the above terms do not necessarily refer to the same implementation or example. Furthermore, the specific features, structures, materials or characteristics described may be combined in a suitable manner in any one or more embodiments or examples.

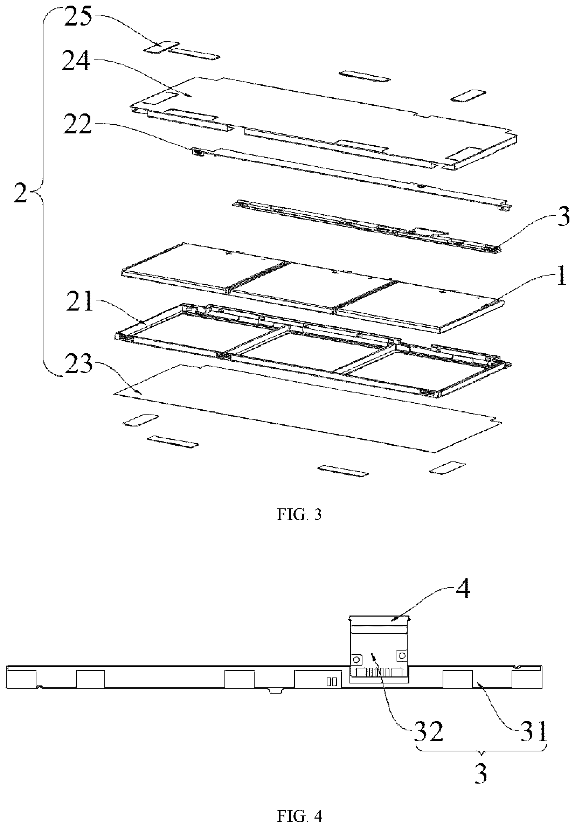

With reference to FIG. 4, a first aspect of the present embodiment provides a protection board 3. The protection board 3 includes a protection board body 31 and a flexible circuit board 32 connected in sequence. An end of the flexible circuit board 32 away from the protection board body 31 is provided with a puller assembly 4.

In the protection board provided by the present embodiment, a puller assembly is provided on the protection board. By directly grabbing the puller assembly, the battery can be disassembled or replaced, which avoids a safety risk of cracking of or damage to the flexible circuit board and thus seriously affecting the safety performance and service life of the battery due to directly taking the flexible circuit board with hands or devices. The protection board of the present embodiment facilitates the disassembly and replacement of the battery, improves the safety performance of the battery and electronic device system end, has a simple structure, and is convenient to be assembled and beneficial to reducing production cost of the battery.

Where, the protection board body 31 can be used to provide overcharge protection, over-discharge protection, over-current protection, and short-circuit protection, etc. for the battery body 1. The flexible circuit board 32 (Flexible Printed Circuit, FPC for short) has good flexibility and can be folded at any angle, which is beneficial to reducing the space occupied by the built-in battery, and the flexible circuit board 32 is used to connect to an electronic device and provides power to the electronic device.

The flexible circuit board 32 can be arranged in a vertical direction without bending. The flexible circuit board 32 can also be arranged in a vertical direction with bending, and two sections connected to a bending section are both arranged in a vertical direction. In this embodiment, there is no further limitation on whether the flexible circuit board 32 will be bent, and those skilled in the art can make adjustment according to whether the electronic device is provided with a protrusion, so that the flexible circuit board 32 fits better with the electronic device, saving the space of the battery.

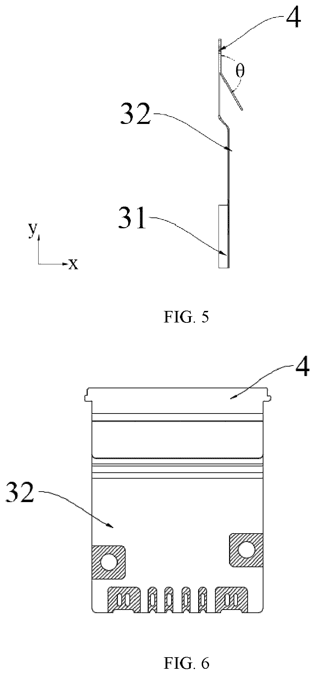

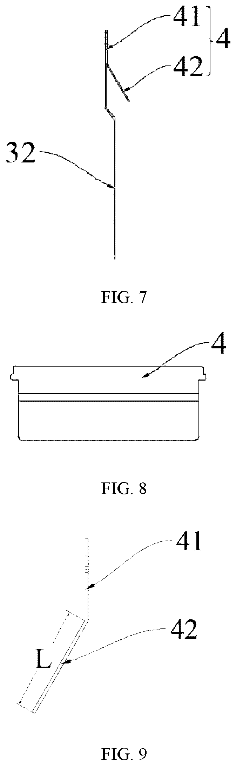

As shown in FIGS. 5 to 9, the puller assembly 4 includes a fixing portion 41 and a puller portion 42 arranged in sequence. The fixing portion 41 is connected to the flexible circuit board 32, and the puller portion 42 is bent at a certain angle relative to the fixing portion 41, for pulling the battery.

An adhesive layer (not shown) is provided between the fixing portion 41 and the flexible circuit board 32. One side of the adhesive layer is bonded to the flexible circuit board 32, and the other side of the adhesive layer is bonded to the fixing portion 41. Therefore, the fixing portion 41 and the flexible circuit board 32 are fixed together through the adhesive layer, which on one hand can enhance the reliability of the connection between the flexible circuit board 32 and the puller assembly 4 and on the other hand can enhance the reliability of the combination of the flexible circuit board 32 and an electronic device system end, preventing the flexible circuit board 32 from being damaged.

Specifically, the fixing portion 41 is arranged along the vertical direction (i.e., y-axis direction in FIG. 5), and the puller portion 42 is bent at a certain angle relative to the fixing portion 41. In this way, the fixing portion 41 is arranged parallel to the flexible circuit board 32, and the puller portion 42 is bent at a certain angle relative to the fixing portion 41, so that there is a certain distance between the puller portion 42 and the flexible circuit board 32, which facilitates grasping the puller portion 42 and enables the battery to be pulled through the puller portion 42.

An included angle between the puller portion 42 and the fixing portion 41 ranges from 90° to 150°, that is, θ in FIG. 5 is in a range from 90° to 150°, which makes it easier to grab the puller portion 42 and pull the battery.

A length of the puller portion 42 ranges from 1 mm to 100 mm, that is, L is 1 mm to 100 mm, which facilitates grasping the puller portion 42 and prevents the puller portion 42 from being too long to occupy the space of the battery.

In the present embodiment, a shape of the puller portion 42 is not further limited. Those skilled in the art can set it according to the actual situation. For example, the shape of the puller portion 42 may be a rectangle, a trapezoid, a triangle, a semicircle, a circle, an arc, or any combination of the above shapes.

The puller portion 42 is a bendable puller portion 42, that is, the puller portion 42 is formed of a bendable material. Therefore, when the electronic device system end has many components, the puller portion 42 can be bent to be fitted with the flexible circuit board 32, which can reduce the space occupied by the puller portion 42. Specifically, the material of the puller portion 42 may be polyimide (PI for short) or steel sheet.

The fixing portion 41 and the puller portion 42 are integrally formed, and a material of the fixing portion 41 is the same as that of the puller portion 42, which is beneficial to improving the structural strength of the puller assembly 4.

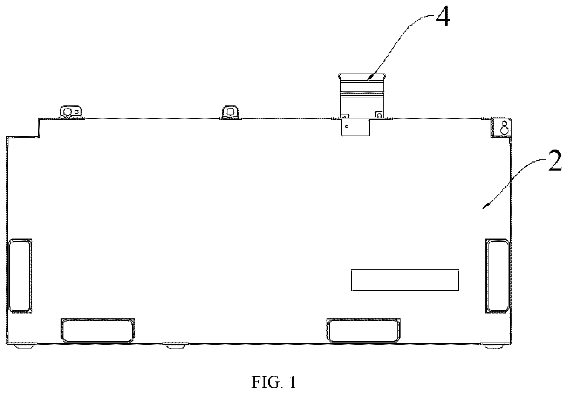

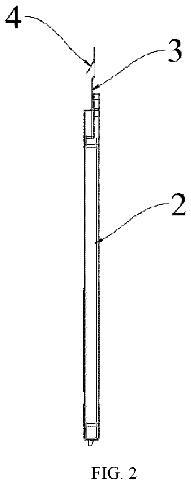

With reference to FIGS. 1 to 3, a second aspect of the present embodiment provides a battery, including a battery body 1, a protection assembly 2 wrapping the battery body 1 inside, and a protection board 3, where the protection board 3 is the protection board 3 shown in the first aspect.

In the battery provided by the present embodiment, a puller assembly is provided on the protection board. By directly grabbing the puller assembly, the battery can be disassembled or replaced, which avoids a safety risk of cracking of or damage to the flexible circuit board and thus seriously affecting the safety performance and service life of the battery due to directly taking the flexible circuit board with hands or devices. The battery of the present embodiment facilitates the disassembly and replacement of the battery, improves the safety performance of the battery and the electronic device system end, has a simple structure, and is convenient to be assembled and beneficial to reducing production cost of the battery.

With reference to FIG. 3, the protection assembly 2 includes a plastic frame 21, a plastic frame head 22, a label protection layer, and a steel sheet 25. The label protection layer includes a first label protection layer 23 and a second label protection layer 24. The plastic frame head 22 is arranged on a top surface of the plastic frame 21, and the plastic frame 21 and the plastic frame head 22 are enclosed to form an accommodation cavity. The battery body 1 is accommodated in the accommodation cavity. The protection board 3 is arranged on a top surface of the plastic frame 21, and the protection board 3 extends beyond the plastic frame head 22, so that one end of the protection board 3 is located inside the protection assembly 2, and the other end of the protection board 3 is located outside the protection assembly 2; the first label protection layer 23 and the second label protection layer 24 is wrapped on outer surfaces of the plastic frame 21 and the plastic frame head 22 to further protect the battery body 1 and prevent the battery body 1 from being damaged. The steel sheet 25 is disposed on the label protection layer, and specifically, the steel sheet 25 can be disposed on both the first label protection layer 23 and the second label protection layer 24, or the steel sheet 25 can also be disposed on the first label protection layer 23 or the second label protection layer 24. Those skilled in the art can set the specific position and quantity of the steel sheet 25 according to the actual situation, as long as it can prevent screws or other sharp parts of a local portion of the electronic device system end from scratching or stabbing the battery body 1. In the present embodiment, the battery body 1 is protected by a three-layer protection structure, which can better protect the battery body 1 and prevent the battery body 1 from being damaged, which is beneficial to extending the service life of the battery body 1.

With reference to FIGS. 4 and 5, the protection board body 31 is located inside the protection assembly 2, the protection board body 31 is close to the top surface of the plastic frame 21. One end of the protection board body 31 is electrically connected to the battery body 1, the other end of the protection board body 31 is connected to the flexible circuit board 32, and the flexible circuit board 32 extends beyond the top surface (i.e., a first end surface) of the plastic frame head 22. That is, the protection board body 31 is located inside the protection assembly 2, and the flexible circuit board 32 extends to outside of the protection assembly 2. An end of the flexible circuit board 32 away from the protection board body 31 is provided with a puller assembly 4, thereby making it easy to pull the battery through the puller assembly 4 and avoid damage to the flexible circuit board 32.

A third aspect of the present embodiment provides an electronic device. The electronic device includes the battery shown in the second aspect.

In the electronic device provided by the present embodiment, a puller assembly is provided on the protection board. By directly grabbing the puller assembly, the battery can be disassembled or replaced, which avoids a safety risk of cracking of or damage to the flexible circuit board and thus seriously affecting the safety performance and service life of the battery due to directly taking the flexible circuit board with hands or devices. The present embodiment facilitates the disassembly and replacement of the battery, improves the safety performance of the battery and the electronic device system end, has a simple structure, and is convenient to be assembled and beneficial to reducing production cost of the battery.

Although the present disclosure is disclosed as above, the protection scope of the present disclosure is not limited thereto. Those skilled in the art can make various changes and modifications without departing from the spirit and scope of the present disclosure, and these changes and modifications will fall within the protection scope of the present disclosure.

## Claims

1. A protection board, comprising: a protection board body and a flexible circuit board connected in sequence, wherein a puller assembly is provided on an end of the flexible circuit board away from the protection board body.

2. The protection board according to claim 1, wherein:
the protection board comprises a connector provided on the end of the flexible circuit board away from the protection board body;
the puller assembly comprises a fixing portion located on a surface of a side of the flexible circuit board away from the connector, and the fixing portion is fixedly connected to the flexible circuit board.

3. The protection board according to claim 2, wherein an adhesive layer is provided between the fixing portion and the flexible circuit board, one side of the adhesive layer is bonded to the flexible circuit board, and the other side of the adhesive layer is bonded to the fixing portion.

4. The protection board according to claim 2, wherein the puller assembly further comprises a puller portion, the puller portion is connected to the fixing portion, and the puller portion is bent relative to the fixing portion.

5. The protection board according to claim 4, wherein an included angle between the puller portion and the fixing portion ranges from 90° to 150°.

6. The protection board according to claim 4, wherein a length of the puller portion ranges from 1 mm to 100 mm.

7. The protection board according to claim 4, wherein the fixing portion and the puller portion are integrally formed.

8. A battery, comprising: a battery body, a protection assembly wrapping the battery body inside, and a protection board, wherein the protection board is the protection board according to any one of claims 1 to 7.

9. The battery according to claim 8, wherein the protection board body is located inside the protection assembly, the protection board body is electrically connected to the battery body, and the flexible circuit board extends to outside of the protection assembly, and the puller assembly is provided on the end of the flexible circuit board away from the protection board body.

10. The battery according to claim 9, wherein the protection assembly comprises a plastic frame, a plastic frame head, and a label protection layer, wherein the plastic frame and the plastic frame head are enclosed to form an accommodation cavity to accommodate the battery body and the protection board body, and the label protection layer is wrapped outside of the plastic frame.

11. An electronic device, comprising the battery according to any one of claims 8 to 10.
